# EUROPEAN PATENT APPLICATION

(11) **EP 1 111 616 A2**
(43) Date of publication of application: **27.06.2001**
(21) Application number: 00125361.6
(22) Date of filing: 30.11.2000
(51) Int. Cl.: G11C 7/16

(54) **Recording medium and information processing device for managing read-in information**

(30) Priority: 01.12.1999 JP 34189699
(71) Applicant: Sony Computer Entertainment Inc., Tokyo 107-0052 (JP)
(72) Inventor: Kawai, Eiji, Minato-ku, Tokyo 107-0052 (JP); Kutaragi, Ken, Minato-ku, Tokyo 107-0052 (JP); Miura, Kazuo, Minato-ku, Tokyo 107-0052 (JP)
(74) Representative: MÜLLER & HOFFMANN Patentanwälte

(57) **Abstract**

A recording medium 10 is provided with a read only memory 12 having a program recorded therein and a non-volatile memory 13 in which a virgin code is written when it is under non-use state. When an information processing device 50 detects the virgin code, it writes the ID code thereof. The information processing device 50 does not read out any program from a recording medium which is not the recording medium 10 in which the ID code thereof is recorded. Therefore, the program can be executed only by the information processing device which is registered in the recording medium 10, whereby the association between the recording medium and the specific information processing device can be strengthened.

## Description

This application claims a priority based on Japanese patent Application No. 11-341896 filed on December 1, 1999, the entire contents of which are incorporated herein by reference for all purposes.

### BACKGROUND OF THE INVENTION

The present invention relates to a recording medium in which a program is recorded, and an information processing device for reading the program from the recording medium and executing the program thus read.

Application programs for games, etc. executed in domestic information processing devices are mainly sold while they are recorded in compact recording media using semiconductor devices such as memory cartridges. Such a memory cartridge is provided with a read only memory therein. These memory cartridges are sold while application programs for games, etc. are recorded therein.

An information processing device which executes each application program has a memory cartridge mount port. When the memory cartridge is mounted in the information processing device, a connection device of the memory cartridge is electrically connected to a connection device of the information processing device and the program recorded in the read only memory is read out into a dynamic memory or the like installed in the information processing device. The information processing device performs the information processing corresponding to the content of the program thus read and supplies an executing environment for a game or the like.

### SUMMARY OF THE INVENTION

Such a recording medium as described above is a compact and easily portable, and it is not necessary to be kept at hand when it is not used. Therefore, a memory cartridge can be used over plural information processing devices. Accordingly, there may occur such a situation that a memory cartridge purchased by one person is used by many and unspecified persons.

However, the memory cartridges are basically sold on the premise that one memory cartridge is used in one information processing device. The above premise has been broken by the situation that one memory cartridge is used by many and unspecified persons.

Therefore, it is desired to strengthen the association between a memory cartridge and a specific information processing device which can use the memory cartridge.

An object of the present invention is to provide a technique of associating a recording medium and an information processing device which reads a program from the recording medium to execute the program.

In order to attain the above object, according to a first aspect of the present invention, there is provided a recording medium equipped with a non-volatile memory area in addition to a read only memory in which a program is recorded. Inherent data of an information processing device which reads out the program from the recording medium can be recorded in the non-volatile memory area of the recording medium.

In the non-volatile memory may be beforehand recorded a code indicating that a recording medium is a new recording medium from which a program has not yet been read out. Further, the frequency at which information can be recorded and the number of information pieces to be recorded can be set in the non-volatile memory.

According to second aspect of the present invention, there is provided an information processing device which collates information recorded in a non-volatile memory of a recording medium with inherent data of the information processing device to judge whether a program recorded in the recording medium can be read out every time the recording medium is mounted in the information processing device. The information processing device may have means for writing inherent data thereof into the non-volatile memory of the recording medium.

### BRIEF DESCRIPTION OF THE DRAWINGS

Fig. 1 is a diagram showing an external appearance of the main body of a game machine (main body of PDA) and a recording medium (memory cartridge) of the present invention;
Fig. 2 is a circuit block diagram showing the inner part of the main body of the game machine and the recording medium;
Fig. 3 is a flowchart showing an example of an operation of the main body of the game machine and the recording medium according to the present invention;
Fig. 4 is a flowchart showing another example of the operation of the main body of the game machine and the recording medium according to the present invention; and
Fig. 5 is a flowchart showing another example of the operation.

### DETAILED DESCRIPTION OF THE PREFERRED EMBODIMENTS

Preferred embodiments according to the present invention will be described hereunder with reference to the accompanying drawings.

In the following embodiment, the present invention is applied to a portable game machine and a recording medium used for the portable game machine.

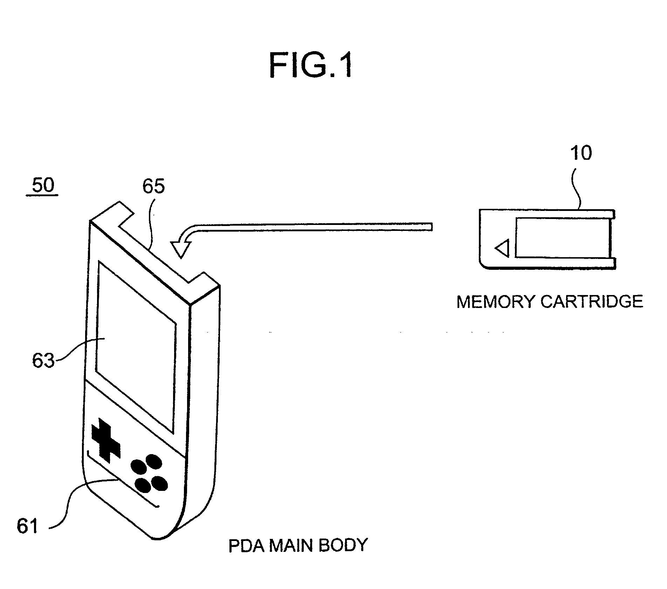

Fig. 1 shows the external appearance of a portable game machine (hereinafter referred to as "PDA") 50 and a recording medium (hereinafter referred to as "memory cartridge") 10 according to an example of the present invention.

PDA 50 is designed in a compact size so as to be portably carried, and also its shape and layout are set so that it can be held by both hands and operated by fingers when it is used. Information is transmitted from the PDA 50 to a user in images and sounds. Since an application program is supplied from the memory cartridge 10, various games, etc. can be enjoyed with only one PDA 50 by exchanging the memory cartridge 10 with another.

The memory cartridge 10 contains a semiconductor device and normally records one game program therein. when an owner of the PDA 50 wants to enjoy a game, it is sufficient for the owner to purchase a memory cartridge 10 in which the game program therefor is recorded.

PDA 50 is provided with a liquid crystal display panel 63 and operating buttons 61 on the front face of the housing thereof. When one of the operating buttons 61 is pushed, the PDA 50 receives information indicating an instruction from the user. The PDA 50 displays visual information through the liquid crystal display panel 63. Further, the PDA 50 outputs audio information from a sound device (speaker).

The memory cartridge 10 is used while it is mounted in the direction of an arrow at the mount port 65 provided at the upper portion of the PDA 50. When the memory cartridge 10 is mounted in the PDA 50, the game program recorded in the memory cartridge 10 is read out into the PDA 50. The PDA 50 executes the game according to the program thus read.

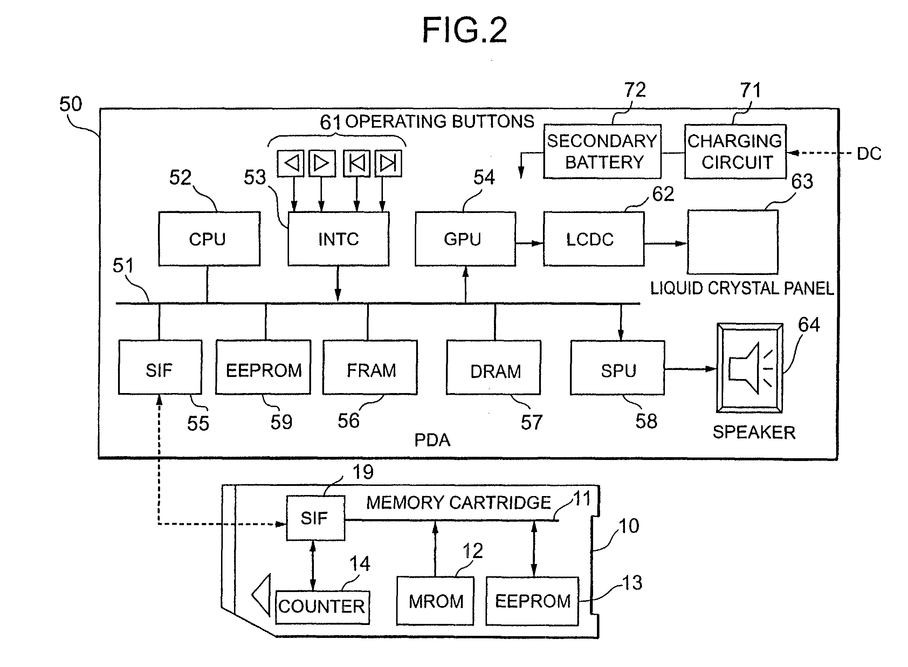

Fig. 2 is a block diagram showing the internal circuit construction of the PDA main body 50 and the memory cartridge 10 .

The memory cartridge 10 has a bus 11, to which a read only memory 12 employing a mask ROM, a non-volatile memory 13 employing a writable EEPROM and a connection device (SIF: Serial Interface) 19 for performing data reception and transmission are connected. Here, SIF 19 may have a control function to serve as a communication control device. In this case, a load of the central processing unit (CPU) 52 of the PDA can be reduced.

A counter 14 for holding a count value is connected to SIF 19. The counter 14 may be directly connected to the bus 11 and it may be provided on the non-volatile memory 13.

A game program is recorded in the read only memory 12 in advance. Normally, the memory cartridge 10 is sold while the game program is recorded in the read only memory 12.

The non-volatile memory 13 is provided with an area in which at least one piece of inherent data of the PDA 50 can be recorded. At the shipping time, this area is set to an initial state where all bits thereof are set to "1" as a virgin code. The initial state is not limited to the above state, and a specific code may be set as the initial state.

The read only memory 12 and the non-volatile memory 13 are constructed so that data may be inputted and outputted to and from the PDA 50 through the bus 11 and SIF 19.

When data is written into the non-volatile memory 13, the counter 14 increments the count value therein. The increment of the count value is controlled by the central processing unit (CPU) 52 of the PDA 50.

PDA 50 is a portable game machine which reads out the game program from the memory cartridge 10 and executes the program. In the PDA 50, the central processing unit (CPU) 52, an interrupt controller (INTC) 53, a graphics processing unit (GPU) 54, a connection device (SIF) 55, a frame memory (FRAM) 56, a dynamic memory (DRAM) 57, a sound processing unit (SPU) 58 and an internal information storage memory 59 are connected to the internal bus 51 of the PDA 50. The connection device 55 may be a communication controller.

The operating buttons 61 which is provided at the outer portion of the PDA 50 are connected to the interrupt controller 53. When one of the operating buttons 61 is pushed, this fact is transmitted through the interrupt controller 53 and the bus 11 to the central processing unit 52. On the basis of this information, the progress of the program or the like is controlled.

The liquid crystal display panel 63 is connected to the graphics processing unit 54 through the liquid crystal device controller 62. The CPU 52 draws characters, etc. of the game on the basis of the information of the frame memory 56 and the dynamic memory 57. The CPU 52 controls the GPU 54 and the LCDC 62 to display characters, character information, etc. on the liquid crystal panel 63. Further, the CPU 52 controls the SPU 58 to output effective sounds, voices or the like from the sound device (speaker) 64.

A charging circuit 71 and a secondary battery 72 are provided in the interior of the PDA main body 50. When direct current is supplied from a power source (not shown) to the charging circuit 71, power is supplied through the secondary battery 72 into built-in devices such as CPU 52, etc.

When the memory cartridge 10 is mounted into the mount port 65 of the PDA 50, the read only memory 12 and the non-volatile memory 13 are allowed to be accessed from the CPU 52 through the SIFs 19, 55 of the memory cartridge 10 and the PDA 50 respectively.

An ID code which is inherent data of the PDA 50 is written in the internal information storage memory 59 of the PDA 50 in advance in a non-volatilized manner. The ID code is represented by the binary system of predetermined number of bits. In order to discriminate from the virgin code, the ID code is set to have at least one figure (bit) of "0" when all the bits of the virgin code is set to "1". It is needless to say that the ID code may be designed in any code system insofar as it is discriminable from the virgin code. In addition to the ID code for identifying the equipment, information such as a manufacturing place, a manufacturing lot, a manufacturing date, etc. may be coded and recorded in the internal information storage memory 59.

In addition to the above ID code, a program for investigating contents recorded in the non-volatile memory of the memory cartridge mounted is written in the internal information storage memory 59 in advance.

The PDA 50 has means for electrically or physically detecting that the memory cartridge 10 is mounted. When it is detected by this means that the memory cartridge 10 is mounted, the CPU 52 of the PDA 50 executes the investigating program in the internal information storage memory 59, and investigates the memory cartridge 10.

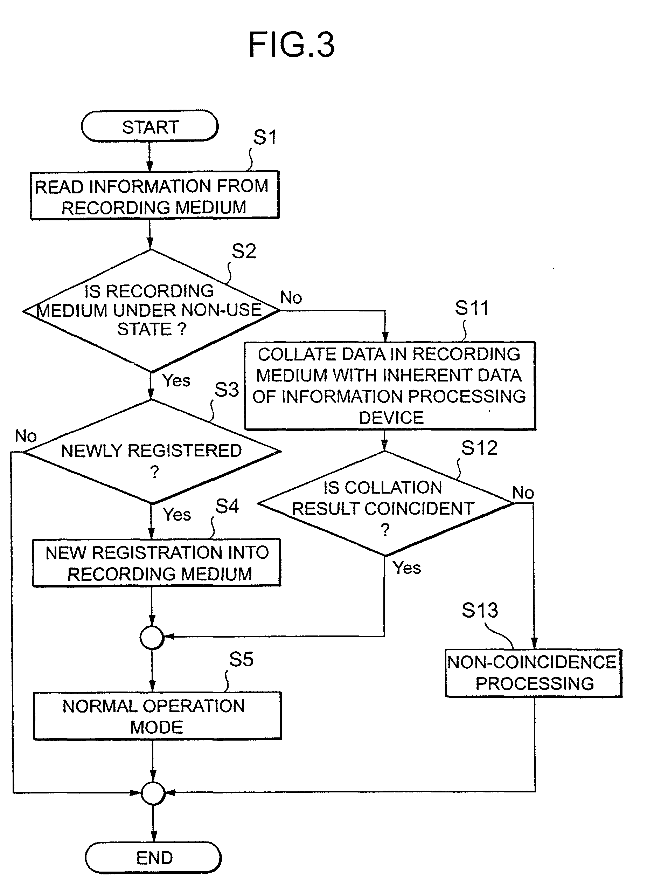

The processing flow of the investigating program will be described with reference to a flowchart of Fig. 3.

In this embodiment, it is assumed that the non-volatile memory 13 in the memory cartridge 10 is provided with an area in which only one ID code is recorded and the writing operation is allowed to be carried out on the area only once for one ID code.

The CPU 52 reads out the data from the area of the non-volatile memory 13 in which the inherent data is recorded (step S1). The CPU 52 judges that the memory cartridge 10 is non-used if the data thus read represent a virgin code, that is, all the bits are set to "1". On the other hand, if the data thus read out does not represent a virgin code, the CPU 52 judges that the memory cartridge 10 has been already used (step S2).

When the data thus read represents the virgin code, the CPU 52 displays, on the liquid crystal panel 63, a button operating method in a case when new registration processing is carried out and a button operating method in a case when no new registration processing is carried out. The CPU 52 of the PDA 50 then waits for an input based on the operating button 61 by a user (step 3).

When such an instruction that no new registration processing is carried out is received from the user, the CPU 52 finishes the processing without reading the game program recorded in the memory cartridge 10 into the PDA 50. In this case, the user of the PDA 50 is required to exchange the memory cartridge with another memory cartridge and then execute another game program, or to pick up the memory cartridge temporarily, re-mount the memory cartridge into the PDA 50 and then re-start the processing from the registration work.

When such an instruction that the new registration processing is carried out is received from the user, the CPU 52 shifts the processing to the registration processing (step S4). The CPU 52 reads out the ID code recorded in the internal information storage memory 59 of the PDA 50, and writes the ID code in the non-volatile memory 13 of the memory cartridge 10 at a place where the virgin code is recorded. Through this processing, the virgin code is overwritten by the ID code, and thus deleted.

The CPU 52 increments the count value of the counter 14 provided in the memory cartridge 10 to record that writing is carried out once. However, when the writing frequency into the non-volatile memory 13 is limited to once like this embodiment, the counter 14 may not be used.

When the writing work and the counting processing are finished, the CPU 52 reads out the game program from the memory cartridge 10, and starts to execute the game program (step S5). This operation corresponds to a normal operation mode.

Next, processing when the data read is not a virgin code will be described. At this time, the data read out from the non-volatile memory 13 of the memory cartridge 10 represent the ID code of the PDA 50 which have been already registered.

The CPU 52 collates the ID code read out from the non-volatile memory 13 with the ID code recorded in the internal information storage memory 59 of the PDA 50 concerned (step S11).

When the collation result indicates non-coincidence, the CPU 52 judges that the ID code registration processing of the memory cartridge 10 was carried out by other PDA 50 than the PDA 50 concerned. The PDA 50 displays on the liquid crystal panel 63 that the memory cartridge mounted is not usable by the PDA concerned, and then finishes the processing without reading out the game program (non-coincidence processing: step S13).

If the collation results indicates coincidence, the CPU 52 judges that the registration processing of the memory cartridge 10 was carried out by the PDA 50 concerned. The CPU 52 shifts the processing to the normal operation mode (step S5) to read out the game program and execute the game.

The above non-coincidence processing (step S13) is the processing when the writing into the non-volatile memory 13 of the memory cartridge 10 is allowed only once for one ID code. At this time, a one-time memory such as a one-time ROM or the like in which writing is allowed only once may be used as the non-volatile memory 13.

Next, a case where the non-volatile memory 13 is provided with an area in which only one ID code is recorded and the writing into the area is allowed plural times. The maximum rewriting frequency is set in advance, and it is set in a memory of the memory cartridge 10 or the PDA 50.

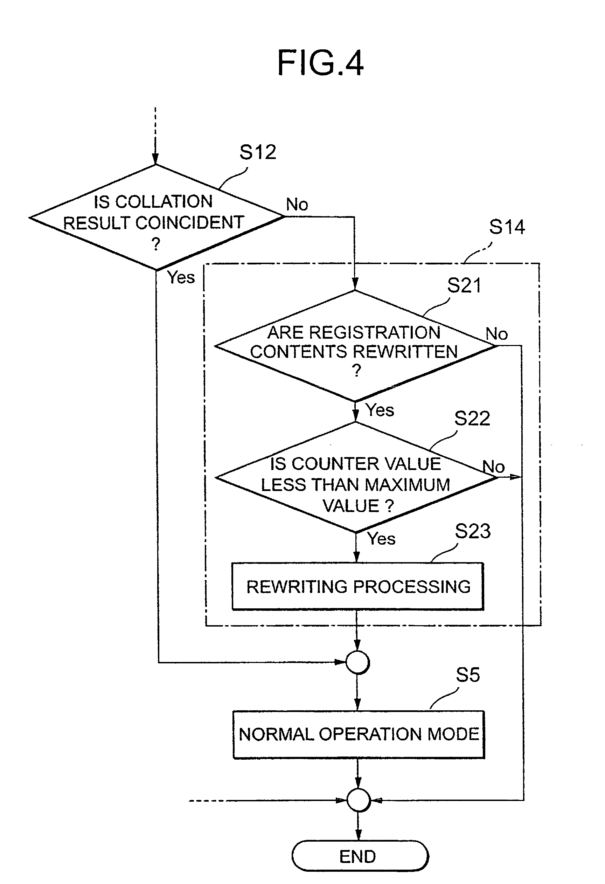

In this case, in place of the non-coincidence processing of Fig. 3 (step S13), the processing shown in Fig. 4 (step S14) is carried out.

If the collation result indicates non-coincidence, the FDA 50 displays on the liquid crystal panel 63 an indication as to whether the registration contents should be rewritten (step S21), and waits for a user's input.

When a registration rewriting indication is received from the user, the count value of the counter 14 is compared with the maximum rewriting frequency (step S22).

If the count value does not reach the maximum rewriting frequency, the rewriting processing (step S23) of overwriting the ID code thereof on the ID code which has been already registered is carried out. The CPU 52 of the PDA 50 increments the count value of the counter 14, and then reads out and executes the game program (normal operation mode: step S5).

If the count value of the counter 14 has reached the maximum rewriting frequency, the CPU 52 displays on the liquid crystal panel 63 the fact that the rewriting is impossible, and finishes the processing without reading out the game program.

when the collation result indicates non-coincidence, the count value of the counter 14 is referred to and it is found that it had reached the maximum rewriting frequency, the fact that the rewriting is impossible may be displayed on the liquid crystal panel 63 without making the display of the step S21, and the processing may be finished without reading the game program.

Further, if a special-purpose circuit is provided in the memory cartridge 10 and the non-volatile memory 13 is prohibited from being rewritten when the count value of the counter 14 reaches the maximum rewriting frequency, unjustified rewriting can be firmly prevented.

In the above embodiment, the non-volatile memory 13 of the memory cartridge 10 is designed so that only one ID code can be recorded in the memory 13. However, the present invention is not limited to this embodiment. For example, the non-volatile memory 13 may be designed so that plural ID codes can be recorded therein at the same time. That is, plural areas where ID codes are respectively recorded are provided. At the shipping time, a virgin code is recorded in each of these areas to set all the bits thereof to "1" (initial state). It is assumed that the writing operation can be carried out on each area only once.

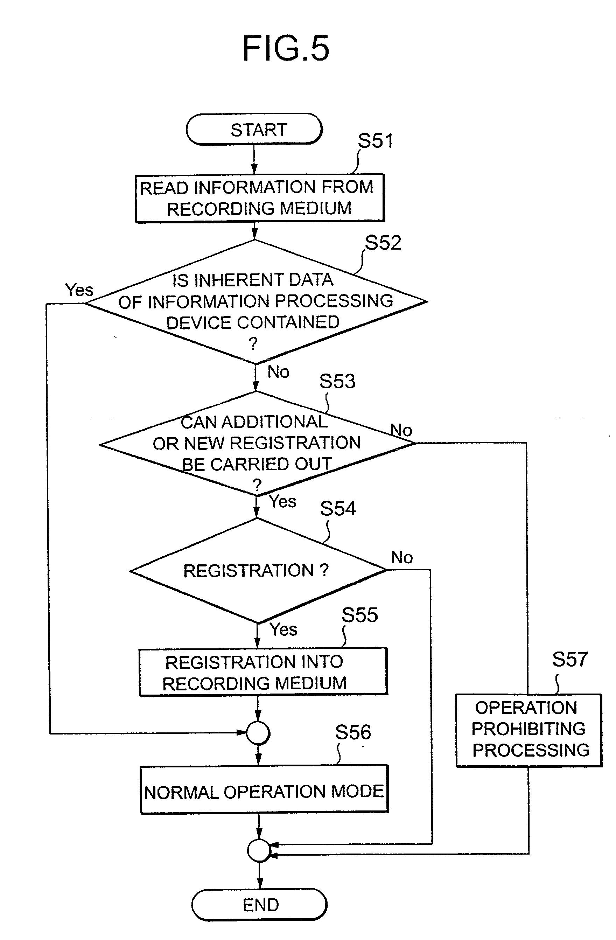

The processing in the above case will be described with reference to Fig. 5.

When the memory cartridge 10 is mounted in the PDA 50, the PDA 50 reads in information recorded in the non-volatile memory 13 (step S51).

The CPU 52 of the PDA 50 searches the read-in information as to every recording unit of ID code, and judges whether the ID code of the PDA 50 concerned is contained (step S52). If the ID code of the PDA 50 concerned is contained, the PDA 50 reads the game program from the memory cartridge 10 and starts to execute the game program (normal operation mode: step S56).

If the ID code of the PDA 50 concerned is not contained, it is checked whether a virgin code is contained in the information read, and it is judged whether additional registration can be carried out (step S53).

If no virgin code exists, all the areas where ID codes should be recorded have been already registered and thus no additional registration can be carried out. Therefore, the processing is shifted to operation prohibiting processing (step S57), and the processing is finished without reading the game program.

If any virgin code exists, the ID code can be written in the corresponding area. Therefore, the CPU 52 displays it on the liquid crystal panel 63 whether the registration processing should be carried out or not, and waits for an input of a user of the PDA (step S54).

When an instruction for the registration processing from the user is received, the ID code of the PDA 50 concerned is recorded in an area where the virgin code of the non-volatile memory 13 is recorded (step 555), whereby the virgin code is deleted and the number of areas where ID codes can be registered is reduced by one.

Thereafter, the game program is read out from the memory cartridge 10 and started (step S56).

When an instruction that the registration processing is not carried out is received, the registration processing is not carried out, and the processing is finished without reading the game program.

This operation enables the same memory cartridge 10 to be used by each of plural PDAs 50 when the same user has the plural PDAs 50. Further, the memory cartridges 10 can be exchanged and used in a limited grup, for example in a family.

In the above-described embodiment, when the ID code thereof is not detected, the read-in operation of the program is not carried out under the control of the CPU 52. In place of this design, it may be modified so that an access to the read only memory 12 in the memory cartridge 10 is not allowed under the control of the memory cartridge 10. In this case, a device for controlling the memory access is provided in the memory cartridge 10.

EEPROM is used as the non-volatile memory 13 of the memory cartridge 10, however, a writable memory such as a flash memory or the like may be used.

In the above-described embodiment, only the ID code is registered in the non-volatile memory 13 of the memory cartridge 10. However, personal information as well as the ID code may be recorded by inputting the personal information at the registration processing time. In this case, when the PDA 50 reads out the program from the memory cartridge 10, the personal information may be displayed on the liquid crystal panel 63 to make the owner of the memory cartridge 10 clear.

The non-volatile memory 13 in the memory cartridge 10 may be independently provided and connected to the bus 11, however, it may be sealed in the same package as at least one of SIF 19, the read only memory 12, etc. to be fabricated as a multi-chip. The non-volatile memory 13 and the read only memory 12 may be mounted on a board by direct bonding while being left as a chip, or by using a size package, whereby it is made difficult to mechanically copy the memory cartridge. Further, when the recording content of the memory cartridge 10 is copied, not only the program, but also the ID code recorded in the non-volatile memory 13 are copied. Accordingly, in this case, the memory cartridge can be also used by only a specific PDA 50.

Further, the present invention is applicable not only to memory cartridges employing semiconductor devices but also to a magnetic or optical recording medium, such as a hard disk, CD-ROM, DVD-ROM etc.

The above-described embodiments relate to the portable game machine and the memory cartridge in which the game program is recorded. However, the present invention is not limited to these embodiments, and may be applied to an information processing device containing an entertainment device or the like, and a recording medium used in the information processing device. The entertainment device means domestic information equipment which is wider in concept than the game machine.

As described above, according to the present invention, by registering the inherent data of the information processing device in the portable storage medium, the portable recording medium and the information processing device are associated with each other, so that an individual portable recording medium can be used by only a specific information processing device.

## Claims

1. A recording medium which is mountable in an information processing device, comprising: a read only memory in which a program is recorded; and a non-volatile memory in which inherent data owned by said information processing device is writable.

2. A recording medium as claimed in claim 1, wherein writing frequency of said inherent data into said non-volatile memory is limited.

3. A recording medium as claimed in claim 1, wherein said non-volatile memory is capable of recording a plurality of pieces of inherent data.

4. A recording medium as claimed in claim 1, wherein under such a state that a program recorded in said read only memory has been never read out into any information processing device, a virgin code representing that said recording medium is a new article is recorded in said non-volatile memory.

5. An information processing device which accepts supply of a program from a recording medium which is detachably mounted in said information processing device comprising:
means for storing inherent data to identify an information processing device; and
means for checking whether the information corresponding to said inherent data is recorded in said recording medium mounted, and accepting said supply of said program recorded in said recording medium when said information corresponding to said inherent data is recorded.

6. An information processing device which accepts supply of a program from a recording medium which is detachably mounted in said information processing device comprising:
means for storing inherent data to identify said information processing device; and
means for checking whether information corresponding to said inherent data is recorded in said recording medium mounted, checking whether said inherent data can be recorded in said recording medium if said information corresponding to said inherent information is not recorded, and recording said inherent information in said recording medium if said inherent information can be recorded in said recording medium.

7. An information processing device which accepts supply of a program from a recording medium which is detachably mounted in said information processing device comprising:
means for storing inherent data to identify said information processing device; and
means for checking whether information corresponding to said inherent data is recorded in said recording medium mounted, checking whether said inherent data can be recorded in said recording medium if the information corresponding to the inherent data is not recorded, recording said inherent data in said recording medium if said inherent data can be recorded in said recording medium, and accepting said supply of the program recorded in said recording medium.

8. An information processing device as claimed in any one of claims 5, 6 and 7, wherein said information processing device is an entertainment device.

9. A method of associating a recording medium and an information processing device in which said recording medium is mountable comprising steps of:
recording inherent data of said information processing device in said information processing device;
checking whether information corresponding to said inherent data of said information processing device is recorded in said recording medium when said recording medium is mounted in said information processing device, and
recording said inherent data in said recording medium, if said information is not recorded in said recording medium.

10. A method of associating a recording medium and an information processing device as claimed in claim 9, wherein number of pieces of said inherent data of said information processing device which are recordable in the recording medium is limited.

11. A method of associating a recording medium and an information processing device as claimed in claim 9, wherein frequency at which said inherent data of said information processing device is recorded in said recording medium is limited.
